(19) Europäisches Patentamt / European Patent Office / Office européen des brevets

(11) **EP 3 039 485 B1**

(12) **EUROPÄISCHE PATENTSCHRIFT**

(45) Veröffentlichungstag und Bekanntmachung des Hinweises auf die Patenterteilung:
**18.10.2023   Patentblatt 2023/42**

(21) Anmeldenummer: **14755388.7**

(22) Anmeldetag: **26.08.2014**

(51) Internationale Patentklassifikation (IPC):
**G03F 7/20** (2006.01)      **G02B 26/08** (2006.01)

(52) Gemeinsame Patentklassifikation (CPC):
**G03F 7/702; G02B 26/0833; G03F 7/70075**

(86) Internationale Anmeldenummer:
**PCT/EP2014/068041**

(87) Internationale Veröffentlichungsnummer:
**WO 2015/028451 (05.03.2015 Gazette 2015/09)**

(54) **MIKROSPIEGEL-ARRAY**

MICROMIRROR ARRAY

SYSTÈME DE MICROMIROIRS

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **29.08.2013   DE 102013217269**

(43) Veröffentlichungstag der Anmeldung:
**06.07.2016   Patentblatt 2016/27**

(73) Patentinhaber: **Carl Zeiss SMT GmbH**
**73447 Oberkochen (DE)**

(72) Erfinder: **ENDRES, Martin**
**89551 Königsbronn (DE)**

(74) Vertreter: **Rau, Schneck & Hübner**
**Patentanwälte Rechtsanwälte PartGmbB**
**Königstraße 2**
**90402 Nürnberg (DE)**

(56) Entgegenhaltungen:
**US-A1- 2004 125 346      US-A1- 2011 318 696**

## Beschreibung

Die Erfindung betrifft ein Mikrospiegel-Array. Die Erfindung betrifft weiterhin eine optische Baugruppe mit einem derartigen Mikrospiegel-Array. Außerdem betrifft die Erfindung eine Beleuchtungsoptik und ein Beleuchtungssystem mit einer derartigen optischen Baugruppe. Schließlich betrifft die Erfindung eine Projektionsbelichtungsanlage mit einer derartigen Beleuchtungsoptik und ein Verfahren zur Herstellung eines mikro- oder nanostrukturierten Bauelements.

In der Mikrolithografie ist es wichtig, ein Objektfeld mit einer vorgegebenen Intensitätsverteilung zu beleuchten. Unerwünschte Intensitätsschwankungen sollen hierbei vermieden werden. Beim Einsatz von Vielspiegel-Anordnungen (Multi Mirror Arrays, MMA) kann es jedoch aufgrund der konstruktionsbedingt vorhandenen Lücken zwischen den Spiegeln zu unerwünschten Intensitätsschwankungen in der Objektebene kommen.

Vielspiegel-Anordnungen für Beleuchtungsoptiken einer Projektionsbelichtungsanlage sind beispielsweise aus der WO 2010/099 807 A1 und der DE 10 2012 207 866.5 bekannt. Weitere Vielspiegel-Anordnungen sind bekannt aus der US2004125346 A1.

Es ist eine Aufgabe der vorliegenden Erfindung, ein Mikrospiegel-Array für eine Projektionsbelichtungsanlage zu verbessern.

Diese Aufgabe wird erfindungsgemäß gelöst durch ein Mikrospiegel-Array wie in Anspruch 1 definiert, umfassend eine Vielzahl von Mikrospiegeln mit Einzel-Reflexionsflächen, welche jeweils eine nicht-rechteckige Form aufweisen, wobei das Mikrospiegel-Array eine parallelogramm-förmige nicht-rechteckige Gesamt-Reflexionsfläche aufweist, und wobei sämtliche Mikrospiegel des Mikrospiegel-Arrays geometrisch ähnlich zueinander ausgebildet sind.

Spezielle Ausführungsformen des Mikrospiegel-Arrays sind in den abhängigen Ansprüchen definiert.

Die Mikrospiegel weisen insbesondere eine polygonale Form auf. Sie sind insbesondere viereckig ausgebildet. Sie können jedoch auch dreieckig ausgebildet sein. Sie sind vorzugsweise parallelogramm-förmig ausgebildet. Sie weisen insbesondere mindestens einen Innenwinkel auf, welcher größer als 100° ist.

Das Mikrospiegel-Array weist insbesondere eine Gesamt-Reflexionsfläche auf, welche abgesehen von einer Skalierung der Form der Einzel-Reflexionsflächen der Mikrospiegel entspricht. Hierbei können die Skalierungsfaktoren in Richtung parallel zu aneinandergrenzenden Seiten der Einzel-Reflexionsflächen unterschiedlich sein.

Die Mikrospiegel weisen insbesondere eine Form auf, welche geometrisch ähnlich zu der des Mikrospiegel-Arrays, insbesondere inklusive der die Mikrospiegel umgebenden Mechanik, ist. Insbesondere die Einzel-Reflexionsflächen weisen eine Form auf, welche geometrisch ähnlich zu der der Gesamt-Reflexionsfläche ist.

Die Mikrospiegel weisen insbesondere Einzel-Reflexionsflächen auf, welche für Strahlung im EUV-Bereich, insbesondere für Strahlung mit einer Wellenlänge im Bereich von 5 nm bis 30 nm, reflektierend ist. Die Einzel-Reflexionsflächen können insbesondere eine Mehrlagen-Beschichtung (Multi Layer Coating) aufweisen.

Die Einzel-Reflexionsflächen der Mikrospiegel können jeweils plan ausgebildet sein. Sie können auch konvex oder konkav gekrümmt ausgebildet sein.

Die Einzelspiegel sind insbesondere verlagerbar. Sie weisen vorzugsweise jeweils mindestens einen, insbesondere mindestens zwei, Kippfreiheitsgrade auf. Sie sind mit anderen Worten vorzugsweise verschwenkbar. Sie können auch einen linearen Freiheitsgrad aufweisen. Sie können insbesondere in Richtung senkrecht zu ihrer Reflexionsfläche verlagerbar sein.

Das Mikrospiegel-Array ist abgesehen von den konstruktionsbedingt vorhandenen Abständen zwischen den Einzelspiegeln lückenlos parkettiert. Die Gesamt-Reflexionsfläche ist mit anderen Worten trennfugenfrei. Das Mikrospiegel-Array weist insbesondere eine Mehrzahl von Zeilen und Spalten auf. Die Mikrospiegel sind mit anderen Worten in Zeilen und Spalten angeordnet. Die Anzahl der Zeilen und Spalten beträgt insbesondere mindestes zwei, insbesondere mindestens drei, insbesondere mindestens fünf, insbesondere mindestens zehn, insbesondere mindestens 20, insbesondere mindestens 30, insbesondere mindestens 40. Die Anzahl der Zeilen und Spalten kann gleich sein. Sie kann auch unterschiedlich sein. Die Gesamtzahl der Mikrospiegel des Mikrospiegel-Arrays kann mehr als 50, insbesondere mehr als 100, insbesondere mehr als 200, insbesondere mehr als 300, insbesondere mehr als 1000 betragen.

Durch eine derartige Ausbildung des Mikrospiegel-Arrays ist es möglich, das Mikrospiegel-Array derart anzuordnen, dass die Zeilen- oder Spaltenorientierung senkrecht zur Scanrichtung steht. Es ist insbesondere möglich, durch diese Anordnung unerwünschte Intensitätsschwankungen in der Objektebene effizient zu unterdrücken. Das Mikrospiegel-Array ist insbesondere derart ausgebildet, dass es eine Begrenzungskante aufweist, welche senkrecht zur Scanrichtung ausgerichtet werden kann.

Gemäß einem Aspekt der Erfindung weist die Gesamt-Reflexionsfläche einen glatten Rand auf. Der Rand der Gesamt-Reflexionsfläche ist insbesondere nicht gezackt. Auch hierdurch werden Intensitätsverluste und/oder Uniformitätsschwankungen in der Objektebene verringert. Außerdem wird hierdurch die Approximation des zu beleuchtenden Objektfeldes durch ein oder mehrere Mikrospiegel-Arrays erleichtert und/oder verbessert.

Es hat sich insbesondere ergeben, dass mit dem erfindungsgemäßen Mikrospiegel-Array eine Beleuchtung des Objektfeldes mit einer Uniformität von besser als 1 %, insbesondere besser als 0,5 %, insbesondere besser als 0,3 %, insbesondere besser als 0,2 %, insbesondere besser als 0,1 % möglich ist. Die angegebenen Werte bezeichnen jeweils eine Obergrenze für die maximale Uniformitätsschwankung, d. h. den maximalen Uniformitätsfehler. Das erfindungsgemäße Mirkospiegel-Array führt insbesondere zu einer erheblichen Verbesserung der Beleuchtung des Objektfeldes.

Die Gesamt-Reflexionsfläche weist insbesondere in Richtung senkrecht zur Scanrichtung einen glatten Rand auf. Sie ist mit anderen Worten durch zwei einander bezüglich der Scanrichtung gegenüber liegende Randabschnitte begrenzt, welche jeweils glatt, insbesondere nicht gezackt, ausgebildet sind. Vorzugsweise sind auch die anderen beiden, einander in Richtung senkrecht zur Scanrichtung gegenüber liegenden Randabschnitte glatt ausgebildet. Letztere können jedoch auch gezackt ausgebildet sein.

Eine weitere Aufgabe der Erfindung besteht darin, eine optische Baugruppe für eine Projektionsbelichtungsanlage zu verbessern. Diese Aufgabe wird durch eine optische Baugruppe mit mindestens einem vorhergehend beschriebenen Mikrospiegel-Array gelöst. Die Vorteile ergeben sich aus denen des Mikrospiegel-Arrays.

Vorzugsweise umfasst die optische Baugruppe eine Vielzahl derartige Mikrospiegel-Arrays. Die Mikrospiegel-Arrays der Baugruppe sind ihrerseits insbesondere in Zeilen angeordnet. Sie können nach Art einer Parkettierung angeordnet sein. Sie sind vorzugsweise modular ausgebildet. Sie können auswechselbar sein.

Außerdem ist es möglich, dass mehrere Mikrospiegel-Arrays derselben Baugruppe mit einer gemeinsamen Steuereinrichtung in signalübertragender Weise verbunden sind. Die optische Baugruppe kann insbesondere eine Steuereinrichtung umfassen, mittels welcher eine Mehrzahl von Mikrospiegel-Arrays dieser Baugruppe steuerbar ist. Es ist insbesondere möglich, sämtliche Mikrospiegel-Arrays einer Baugruppe mit einer einzigen derartigen Steuereinrichtung anzusteuern.

Die Steuereinrichtung dient insbesondere der Steuerung der Verlagerung, d. h. der Positionierung, der Einzelspiegel.

Die Anzahl der Mikrospiegel-Arrays der Baugruppe beträgt insbesondere mindestens zwei, insbesondere mindestens drei, insbesondere mindestens vier, insbesondere mindestens acht, insbesondere mindestens fünfzehn, insbesondere mindestens dreißig, insbesondere mindestens 100, insbesondere mindestens 300.

Die optische Baugruppe ist insbesondere als mikroelektromechanisches System (MEMS) ausgebildet.

Eine weitere Aufgabe der Erfindung besteht darin, eine Beleuchtungsoptik zur Überführung von Beleuchtungsstrahlung von einer Strahlungsquelle in ein Objektfeld zu verbessern. Diese Aufgabe wird gelöst durch eine Beleuchtungsoptik mit einer optischen Baugruppe gemäß der vorhergehenden Beschreibung.

Gemäß einem Aspekt der Erfindung ist das mindestens eine Mikrospiegel-Array jeweils derart angeordnet, dass es bei Beaufschlagung mit Beleuchtungsstrahlung jeweils zu einem Beleuchtungsfeld in der Objektebene führt, welches in Scanrichtung eine Berandung aufweist, welche einer entsprechenden Berandung des Objektfeldes entspricht. Im Falle eines geraden Objektfeldes mit einem Rand senkrecht zur Scanrichtung ist die Berandung des Beleuchtungsfeldes ebenfalls geradlinig, insbesondere parallel, zum Rand des Objektfeldes. Dies kann insbesondere durch eine geradlinige Berandung der Gesamt-Reflexionsfläche des Mikrospiegel-Arrays erreicht werden. Die Mikrospiegel-Arrays sind insbesondere derart angeordnet, dass jeweils eine ihrer Begrenzungskanten senkrecht zur Scanrichtung ausgerichtet ist.

Im Falle eines gekrümmten Objektfeldes kann auch das Beleuchtungsfeld eine entsprechend gekrümmte erste Berandung aufweisen. Die Gesamtreflexionsfläche des Mikrospiegel-Arrays kann hierbei jedoch trotzdem einen geradlinigen Rand aufweisen. Dieser kann durch zwischen dem Mikrospiegel-Array und dem Beleuchtungsfeld angeordnete optische Elemente in ein Beleuchtungsfeld mit einem gekrümmten Rand abgebildet werden.

Durch eine derartige Ausbildung des Mikrospiegel-Arrays lässt sich die Effizienz der Beleuchtung des Objektfeldes sicherstellen und/oder verbessern.

Gemäß einem weiteren Aspekt der Erfindung ist die Berandung des Beleuchtungsfeldes entgegen der Scanrichtung, d. h. die der ersten Berandung gegenüberliegende, zweite Berandung, entsprechend ausgebildet. Die erste und zweite Berandung können insbesondere parallelversetzt zueinander ausgebildet sein. Sie können auch unterschiedliche Krümmungsradien aufweisen.

Gemäß einem weiteren Aspekt der Erfindung weisen die beiden bezüglich der Scanrichtung einander gegenüberliegenden Berandungen des Beleuchtungsfeldes einen Abstand auf, welcher der effektiv für die Beleuchtung des Retikels nutzbaren Größe des Objektfeldes ins Scanrichtung inklusive jeweils einem randseitigen Toleranzbereich entspricht. Die effektiv für die Beleuchtung des Retikels nutzbare Größe des Objektfeldes in Scanrichtung, auch effektive Schlitzlänge genannt, entspricht dabei der vom Objektiv bereitgestellten Größe abzüglich der Toleranzen für Fertigung, Justage und Betriebsstabilität.

Das Mikrospiegel-Array ist insbesondere jeweils derart ausgebildet, dass es in einer Richtung, welche der Beleuchtung des Objektfeldes in Scanrichtung entspricht, in eine ganzzahlige Anzahl von Mikrospiegel-Gruppen unterteilbar ist, wobei jede dieser Mikrospiegel-Gruppen bei Beaufschlagung mit Beleuchtungsstrahlung jeweils zu einem Beleuchtungsfeld in der Objektebene führt, welches in Scanrichtung eine Höhe $h_{BF}$ aufweist, welche der Höhe $h_{OF}$ des Objektfeldes in Scanrichtung exklusive den randseitigen Toleranzbereichen entspricht. Das Mikrospiegel-Array ist mit anderen Worten insbesondere derart ausgebildet, dass es in einer der Scanrichtung entsprechenden Richtung in eine ganzzahlige Anzahl virtueller Facetten unterteilbar ist. Hierbei ist jede der Facetten insbesondere derart ausgebildet, dass die Größe ihres Bildes in Scanrichtung im Retikel der effektiven Schlitzlänge entspricht.

Hierdurch kann erreicht werden, dass die senkrecht zur Scanrichtung verlaufenden Ränder der Gesamtreflexionsfläche des Mikrospiegel-Arrays nicht in das Nutzgebiet, insbesondere nicht in das Objektfeld, abgebildet werden.

Gemäß einem weiteren Aspekt der Erfindung weist die Gesamt-Reflexionsfläche des Mikrospiegel-Arrays eine Breite $b_R$ und eine Höhe $h_R$ auf, wobei die Höhe $h_R$ einem vorgegebenen Vielfachen der Ausdehnung des zu beleuchtenden Objektfeldes in Scanrichtung entspricht. Die Höhe $h_R$ der Gesamt-Reflexionsfläche entspricht insbesondere einem ganzzahligen Vielfachen, der effektiv für die Beleuchtung des Retikels nutzbaren Ausdehnung des Objektfeldes in Scanrichtung multipliziert mit dem Inversen des Abbildungsmaßstabs der Beleuchtungsoptik. Unter der effektiv für die Beleuchtung des Retikels nutzbaren Ausdehnung des Objektfeldes sei hierbei wiederum die Ausdehnung des Beleuchtungsfeldes in Scanrichtung abzüglich der randseitigen Toleranzbereiche verstanden. Die effektiv nutzbare Ausdehnung des Objektfeldes in Scanrichtung liegt insbesondere im Bereich von 1 mm bis 10 cm, insbesondere im Bereich von 3 mm bis 3 cm, insbesondere im Bereich von 6 mm bis 1 cm.

Gemäß einem weiteren Aspekt der Erfindung sind die Mikrospiegel-Arrays in Zeilen angeordnet, wobei die Mikrospiegel-Arrays mindestens zweier benachbarter Zeilen unterschiedliche Scherwinkel aufweisen. Die Mikrospiegel-Arrays benachbarter Zeilen können insbesondere in entgegengesetzte Richtung, parallel beziehungsweise antiparallel zu der Zeilenrichtung geschert sein. Die Zeilen können insbesondere alternierend aus Mikrospiegel-Arrays zweier unterschiedlicher Scherungen gebildet werden. Hierbei können die Mikrospiegel-Arrays benachbarter Zeilen jeweils dem Betrag nach dieselben Scherwinkel aufweisen.

Durch eine Anordnung der Mikrospiegel-Arrays in Zeilen mit unterschiedlicher, insbesondere mit alternierender Scherung, lassen sich die Eigenschaften der Beleuchtung des Objektfeldes verbessern.

Eine weitere Aufgabe der Erfindung besteht darin, ein Beleuchtungssystem für eine Projektionsbelichtungsanlage zu verbessern. Diese Aufgabe wird durch ein Beleuchtungssystem mit einer Beleuchtungsoptik gemäß der vorhergehenden Beschreibung und einer Strahlungsquelle zur Erzeugung von Beleuchtungsstrahlung gelöst.

Bei der Strahlungsquelle kann es sich insbesondere um eine EUV-Strahlungsquelle handeln. Die Strahlungsquelle kann somit insbesondere Beleuchtungsstrahlung im EUV-Bereich, insbesondere im Wellenlängenbereich von 5 nm bis 30 nm, erzeugen. Andere Strahlungsquellen, insbesondere DUV- oder VUV-Strahlungsquellen oder Strahlungsquellen zur Erzeugung von Beleuchtungsstrahlung im sichtbaren Bereich, insbesondere Laser, sind ebenfalls möglich.

Gemäß einem Aspekt der Erfindung ist das Beleuchtungssystem derart ausgebildet, dass das Objektfeld mit einer Uniformität von besser als 1 %, insbesondere besser als 0,5 %, insbesondere besser als 0,3 %, insbesondere besser als 0,2 %, insbesondere besser als 0,1 % beleuchtet ist. Die angegebenen Werte bezeichnen jeweils eine Obergrenze für die maximale Uniformitätsschwankung, d. h. den maximalen Uniformitätsfehler. Es hat sich herausgestellt, dass dies mit Hilfe der erfindungsgemäßen Baugruppe, insbesondere mit Hilfe des Mikrospiegel-Arrays möglich ist. Durch die erfindungsgemäße Ausbildung des Mikrospiegel-Arrays konnte dessen Beitrag zu Uniformitätsschwankungen reduziert werden.

Mit Hilfe des Mikrospiegel-Arrays lässt sich insbesondere die Uniformität, also die Homogenität der Scanning-Energie (SE) über die Feldhöhe x verbessern, also diejenige Energie bzw. Strahlungsintensität, die ein Feldpunkt, der über das Objektfeld gescannt wird, integriert über alle Richtungen sieht.

Generell gilt

$$SE (x)= \int E(x,y)dy,$$

wobei
E (x, y), die Intensitätsverteilung in der x-y-Feldebene, abhängig von x und y ist.

Als Maß für die Uniformität der Scanning-Energie in der Feldebene gilt die Variation der Scanning-Energie über die Feldhöhe. Die Uniformität wird also durch nachfolgende Beziehung für den Uniformitätsfehler in Prozent beschrieben:

$$\Delta SE = \frac{SE_{max} - SE_{min}}{SE_{max} + SE_{min}} \times 100 \, [\%]$$

Hierbei ist:

$\Delta SE$: der Uniformitätsfehler bzw. die Variation der Scanning-Energie in %,
$SE_{Max}$: maximaler Wert der Scanning-Energie, und
$SE_{Min}$: minimaler Wert der Scanning-Energie.

Eine weitere Aufgabe der Erfindung besteht darin, eine Projektionsbelichtungsanlage für die Mikrolithografie zu verbessern. Diese Aufgabe wird durch eine Projektionsbelichtungsanlage mit einer Beleuchtungsoptik gemäß der vorhergehenden Beschreibung und einer Projektionsoptik gelöst. Die Vorteile ergeben sich aus den vorhergehend beschriebenen.

Eine weitere Aufgabe der Erfindung besteht darin, ein Verfahren zur Herstellung eines mikro- oder nanostrukturierten Bauelements zu verbessern. Diese Aufgabe wird durch ein Verfahren unter Bereitstellung einer erfindungsgemäßen Projektionsbelichtungsanlage gelöst. Die Vorteile ergeben sich aus den vorhergehend beschriebenen.

Weitere Details, Merkmale und Vorteile der Erfindung ergeben sich aus der Beschreibung eines Ausführungsbeispiels anhand der Zeichnungen. Es zeigen:

Fig. 1    schematisch einen Meridionalschnitt durch eine Projektionsbelichtungsanlage für die EUV-Projektionslithografie,

Fig. 2    schematisch eine Aufsicht eines Mikrospiegel-Arrays,

Fig. 3    eine Ausschnittsvergrößerung des Bereichs III des Mikrospiegel-Arrays gemäß Fig. 2,

Fig. 4    schematisch eine zweidimensionale Projektion einer dreidimensionalen Anordnung von Mikrospiegel-Arrays eines Facettenspiegels,

Fig. 5    schematisch eine Darstellung zur Verdeutlichung der Beleuchtung eines Objektfeldes, wobei die Anteile einzelner Mikrospiegel eines der Mikrospiegel-Arrays gemäß einer der Fig. 2 bis 4 exemplarisch dargestellt sind, und wobei exemplarisch randseitige Toleranzbereiche in Scanrichtung verdeutlicht sind,

Fig. 6    eine Darstellung entsprechend Fig. 5 mit einer alternativen Anordnung der Mikrospiegel innerhalb eines Mikrospiegel-Arrays,

Fig. 7    eine Ausschnittvergrößerung des Bereichs VII aus Fig. 4,

Fig. 8    eine Ausschnittvergrößerung des Bereichs VIII aus Fig. 7, und

Fig. 9    eine Darstellung gemäß Fig. 4 mit einer alternativen Anordnung der Mikrospiegel-Arrays.

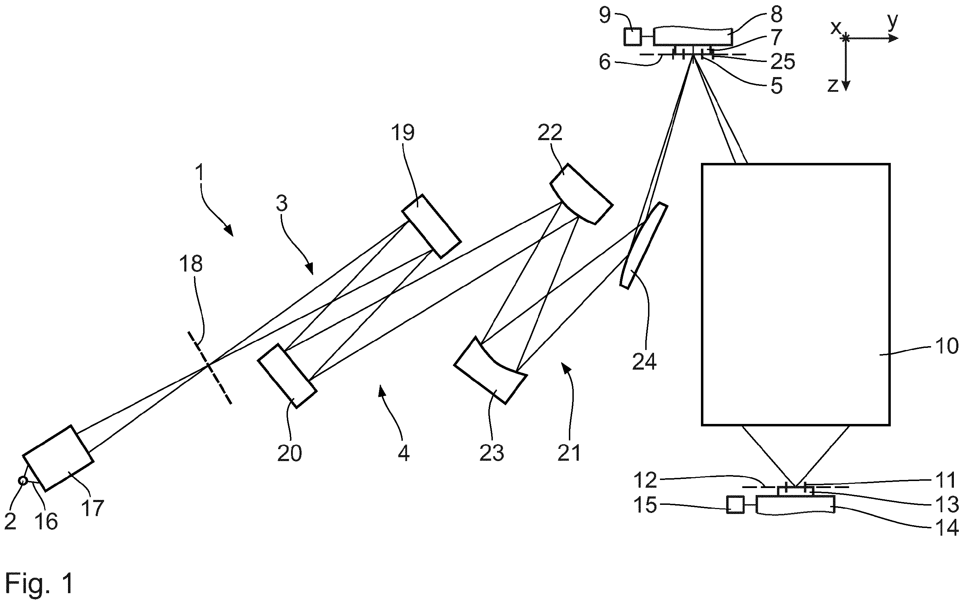

Fig. 1 zeigt schematisch in einem Meridionalschnitt eine Projektionsbelichtungsanlage 1 für die Mikro-Lithographie. Zur Projektionsbelichtungsanlage 1 gehört eine Licht- bzw. Strahlungsquelle 2. Ein Beleuchtungssystem 3 der Projektionsbelichtungsanlage 1 hat eine Beleuchtungsoptik 4 zur Belichtung eines Objektfelds 5 einer Objektebene 6. Das Beleuchtungssystem 3 führt insbesondere zur Beleuchtung eines Beleuchtungsfeldes 25 in der Objektebene 6. Das Beleuchtungsfeld 25 ist vorzugsweise so groß wie das zu beleuchtende Objektfeld 5. Das Beleuchtungsfeld 25 ist in Scanrichtung möglichst so groß wie das zu beleuchtende Objektfeld 5, aber nicht größer. In Richtung senkrecht zur Scanrichtung ist das Beleuchtungsfeld 25 vorzugsweise mindestens so groß wie das Objektfeld 5, aber nicht kleiner. Das Beleuchtungsfeld 25 ist in Scanrichtung insbesondere um randseitige Toleranzbereiche 40 kleiner als das Objektfeld 5. Eine Überstrahlung in Scanrichtung wird hierdurch zuverlässig vermieden. Belichtet wird hierbei ein Objekt in Form eines im Objektfeld 5 angeordneten Retikels 7, das von einem Objekt- beziehungsweise Retikelhalter 8 gehalten ist. Das Retikel 7 wird auch als Lithographiemaske bezeichnet. Der Objekthalter 8 ist über einen Objektverlagerungsantrieb 9 längs einer Verlagerungsrichtung verlagerbar. Die Verlagerungsrichtung wird auch als Scanrichtung bezeichnet. Eine Projektionsoptik 10 dient zur Abbildung des Objektfeldes 5 in ein Bildfeld 11 in einer Bildebene 12. Abgebildet wird eine Struktur auf dem Retikel 7 auf eine lichtempfindliche Schicht eines im Bereich des Bildfeldes 11 in der Bildebene 12 angeordneten Wafers 13. Der Wafer 13 wird von einem Waferhalter 14 gehalten. Der Waferhalter 14 ist über einen Waferverlagerungsantrieb 15 synchronisiert zum Objekthalter 8 ebenfalls längs der Verlagerungsrichtung verlagerbar.

Bei der Strahlungsquelle 2 handelt es sich um eine EUV-Strahlungsquelle mit einer emittierten Nutzstrahlung im Bereich zwischen 5 nm und 30 nm. Es kann sich dabei um eine Plasmaquelle, beispielsweise um eine GDPP-Quelle (Plasmaerzeugung durch Gasentladung, gasdischarge-produced plasma) oder um eine LPP-Quelle (Plasmaerzeugung durch Laser, laserproduced plasma) handeln. Auch eine Strahlungsquelle, die auf einem Synchrotron oder auf einem freien Elektronenlaser (FEL) basiert, ist für die Strahlungsquelle 2 einsetzbar. Informationen zu einer derartigen Strahlungsquelle findet der Fachmann beispielsweise aus der US 6,859,515 B2. EUV-Strahlung 16, die von der Strahlungsquelle 2 ausgeht, wird von einem Kollektor 17 gebündelt. Ein entsprechender Kollektor ist aus der EP 1 225 481 A bekannt. Nach dem Kollektor 17 propagiert die EUV-Strahlung 16 durch eine Zwischenfokusebene 18, bevor sie auf einen Feldfacettenspiegel 19 trifft. Der Feldfacettenspiegel 19 ist ein erster Facettenspiegel der Beleuchtungsoptik 4. Der Feldfacettenspiegel 19 hat eine Vielzahl von Einzelspiegeln, die in der Fig. 1 nicht dargestellt sind. Der Feldfacettenspiegel 19 ist in einer Ebene der Beleuchtungsoptik 4 angeordnet, die zur Objektebene 6 optisch konjugiert ist.

Die EUV-Strahlung 16 wird nachfolgend auch als Beleuchtungslicht oder als Abbildungslicht bezeichnet.

Es ist auch möglich, eine Strahlungsquelle 2, welche Beleuchtungslicht in einem anderen Wellenlängenbereich erzeugt, einzusetzen. Bei der Strahlungsquelle 2 kann es sich insbesondere auch um eine DUV-oder VUV-Strahlungsquelle handeln. Es kann sich auch um eine Strahlungsquelle zur Erzeugung von Beleuchtungsstrahlung im sichtbaren Wellenlängenbereich handeln.

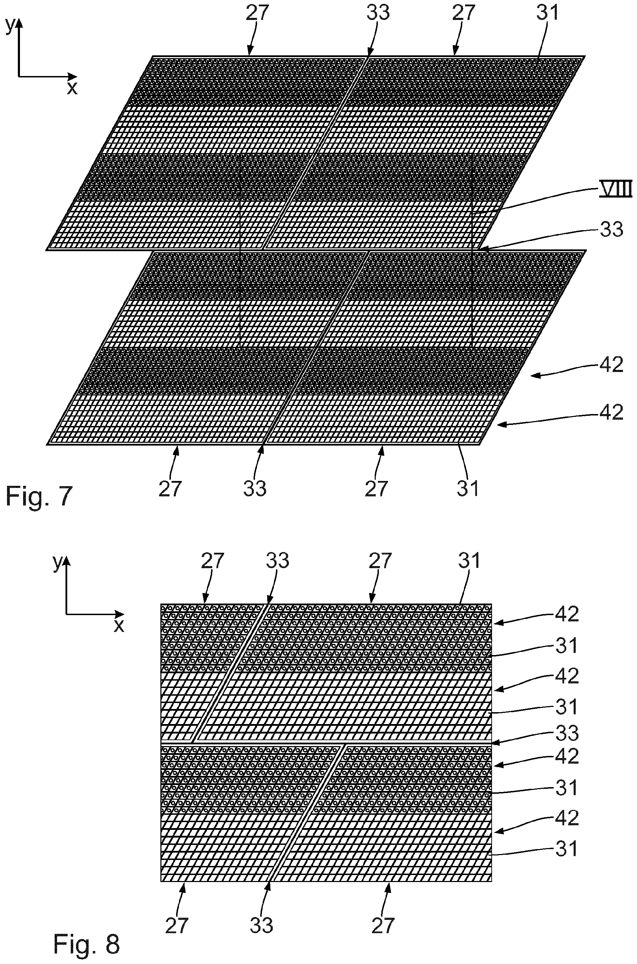

Nach dem Feldfacettenspiegel 19 wird die EUV-Strahlung 16 von einem Pupillenfacettenspiegel 20 reflektiert. Der Pupillenfacettenspiegel 20 ist ein zweiter Facettenspiegel der Beleuchtungsoptik 4. Der Pupillenfacettenspiegel 20 ist in einer Pupillenebene der Beleuchtungsoptik 4 angeordnet, die zur Zwischenfokusebene 18 und zu einer Pupillenebene der Projektionsoptik 10 optisch konjugiert ist oder mit dieser Pupillenebene zusammenfällt. Der Pupillenfacettenspiegel 20 hat eine Mehrzahl von Pupillenfacetten, die in der Fig. 1 nicht dargestellt sind. Mit Hilfe der Pupillenfacetten des Pupillenfacettenspiegels 20 und einer nachfolgenden abbildenden optischen Baugruppe in Form einer Übertragungsoptik 21 mit in der Reihenfolge des Strahlengangs bezeichneten Spiegeln 22, 23 und 24 werden nachfolgend noch näher beschriebene Einzelspiegel-Gruppen 25 (vgl. Fig. 7) des Feldfacettenspiegels 19 in das Objektfeld 5 abgebildet. Der letzte Spiegel 24 der Übertragungsoptik 21 ist ein Spiegel für streifenden Einfall ("Grazing Incidence-Spiegel").

Zur Erleichterung der Beschreibung von Lagebeziehungen ist in der Fig. 1 ein kartesisches xyz-Koordinatensystem als globales Koordinatensystem für die Beschreibung der Lageverhältnisse von Komponenten der Projektionsbelichtungsanlage 1 zwischen der Objektebene 6 und der Bildebene 12 eingezeichnet. Die x-Achse verläuft in der Fig. 1 senkrecht zur Zeichenebene in diese hinein. Die y-Achse verläuft in der Fig. 1 nach rechts und parallel zur Verlagerungsrichtung des Objekthalters 9 und des Waferhalters 14. Die z-Achse verläuft in der Fig. 1 nach unten, also senkrecht zur Objektebene 6 und zur Bildebene 12.

Die x-Dimension über das Objektfeld 5 bzw. das Bildfeld 11 wird auch als Feldhöhe bezeichnet.

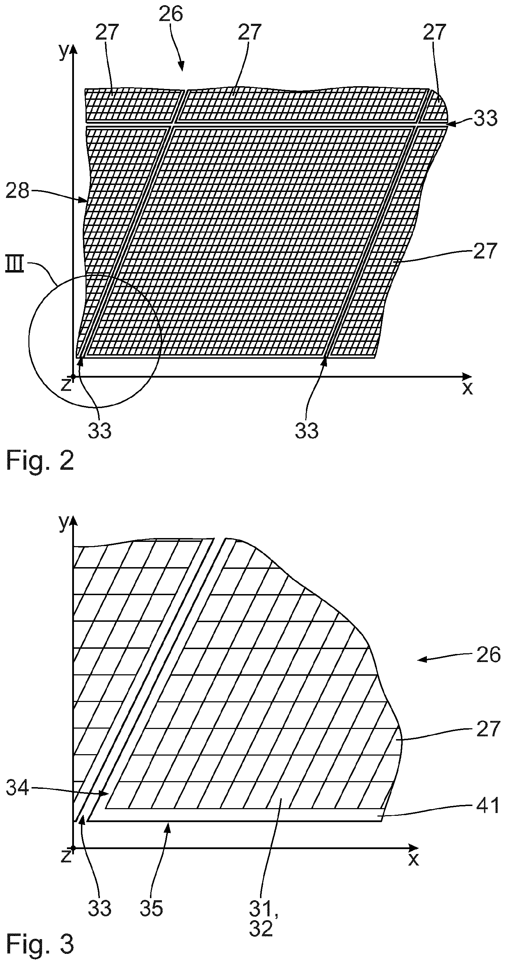

Die Figuren 2 und 3 zeigen Ausschnitte einer optischen Baugruppe 26 mit einer Mehrzahl von Vielspiegel-Anordnungen 27 (Multi Mirror Arrays, MMAs).

Für weitere Details des allgemeinen Aufbaus der Projektionsbelichtungsanlage 1 und deren Funktionsweise sei auf die DE 10 2012 207 866.5 verwiesen, die hiermit als Ganzes Bestandteil der vorliegenden Anmeldung sein soll.

Die optische Baugruppe 26 kann insbesondere Bestandteil des Feldfacettenspiegels 19 sein. Sie kann auch Bestandteil des Pupillenfacettenspiegels 20 oder eines anderen Elements der Beleuchtungsoptik 4 sein.

Zur Erleichterung der Beschreibung von Lagebeziehungen ist in den Figuren 2 bis 9 ein kartesisches xyz-Koordinatensystem als lokales Koordinatensystem der optischen Baugruppe 26 eingezeichnet. Die y-Richtung des globalen Koordinatensystems nach Fig. 1, also die Verlagerungsrichtung für das Retikel 7 und den Wafer 13, und die y-Richtung des lokalen Koordinatensystems in den Figuren 2 bis 9 entsprechen hierbei einander. Hierunter sei verstanden, dass die Abbildung der optischen Komponenten der Beleuchtungsoptik 4 derart ist, dass die y-Richtung des lokalen Koordinatensystems zumindest näherungsweise parallel zur y-Richtung des globalen Koordinatensystems, insbesondere parallel zur Scanrichtung, verläuft.

Die optische Baugruppe 26 umfasst eine Vielzahl von MMAs 27. Die MMAs 27 sind in Zeilen 28 angeordnet. Hierbei sind die Zeilen 28 jeweils parallel zur x-Richtung ausgerichtet. Die Zeilen 28 sind somit senkrecht zur y-Richtung, welche parallel zur Scanrichtung ist.

Die MMAs 27 sind insbesondere entsprechend den Breitenkreisen einer oder mehrerer Kugeln angeordnet. Hierbei verlaufen die Breitengrade jeweils senkrecht zur effektiven Scanrichtung auf dem Feldfacettenspiegel 19. Die Positionierung der MMAs 27 entlang des Breitengrades kann insbesondere derart gewählt werden, dass es zu einer optimalen Abdeckung des Feldfacettenspiegels kommt. Hierunter sei insbesondere verstanden, dass die Anzahl der zur Abdeckung des Feldfacettenspiegels 19 benötigten MMAs 27 minimiert wird. Vorzugsweise sind die MMAs 27 derart angeordnet, dass die benötigten Kippwinkel zur Ausleuchtung des Pupillenfacetten möglichst klein sind und/oder die Abbildungsmaßstäbe zwischen den einzelnen Beleuchtungskanälen möglichst wenig variieren, und/oder das Fernfeld der Strahlungsquelle 2 mit möglichst wenigen Bauteilen und möglichst kleinen Lücken überdeckt wird. Die MMAs 27 sind jeweils plan ausgebildet. Sie können jedoch auf einer gekrümmten Fläche, insbesondere einer ellipsoidalen Fläche oder einer Kugeloberfläche angeordnet werden. Für Details der dreidimensionalen Anordnung der MMAs 27 sei auf die DE 10 2012 207 866.5 verwiesen.

Die MMAs 27 sind jeweils parallelogrammförmig ausgebildet. Sie sind insbesondere nicht-rechteckig ausgebildet. Sie weisen insbesondere einen Innenwinkel auf, welcher größer als 100° ist.

Die MMAs 27 umfassen jeweils eine Vielzahl von Einzelspiegeln 31, welche aufgrund ihrer Dimensionierung auch als Mikrospiegel 31 bezeichnet werden. Die Einzelspiegel 31 können insbesondere jeweils Seitenlängen im Bereich von 10 μm bis 10 mm, insbesondere im Bereich von 100 μm bis 1 mm, insbesondere im Bereich von 300 μm bis 800 μm aufweisen.

Die Einzelspiegel 31 weisen jeweils Einzel-Reflexionsflächen 32 auf. Die Einzel-Reflexionsflächen 32 sind parallelogrammförmig ausgebildet. Sie sind insbesondere geometrisch ähnlich zur Gesamt-Reflexionsfläche des MMA 27.

Die Einzelspiegel 31 sind insbesondere nach Art einer Parkettierung angeordnet. Das MMA 27 ist mit anderen Worten abgesehen von den konstruktionsbedingt vorhandenen Abständen zwischen den Einzel-Reflexionsflächen 32 lückenlos parkettiert. Die Abstände zwischen den Einzelspiegeln 31 eines MMA 27 sind insbesondere kleiner als 100 μm, insbesondere kleiner als 30 μm, insbesondere kleiner als 10 μm. Das MMA 27 ist insbesondere trennfugenfrei. Andererseits kann zwischen zwei benachbarten MMAs 27 eine Trennfuge 33 vorhanden sein. Die Trennfuge 33 ist möglichst schmal. Sie kann eine Trennfugenbreite von weniger als 1 mm, insbesondere weniger als 300 μm, insbesondere weniger als 100 μm aufweisen. Da die MMAs 27 außerdem einen umlaufenden Rand 41 aufweisen, sind die Gesamt-Reflexionsflächen zweier benachbarter MMAs 27 durch zwei dieser Ränder 41 und die Trennfuge 33 voneinander beabstandet. Der Abstand der Gesamt-Reflexionsflächen zweier benachbarter MMAs 27 ist vorzugsweise kleiner als 1 mm. Er ist vorzugsweise kleiner als die Seitenlänge eines der Einzelspiegel 31 in der entsprechenden Richtung.

Die Einzelspiegel 31 sind zur individuellen Ablenkung der Beleuchtungsstrahlung 16 verlagerbar. Sie sind hierfür jeweils mit einem Aktuator verbunden, welcher in den Figuren nicht dargestellt ist. Bezüglich der Verlagerbarkeit der Einzelspiegel 31 und der hierfür vorgesehenen Aktuatoren sei beispielsweise auf die DE 10 2012 207 866.5 verwiesen.

Die Einzelspiegel 31 sind ebenfalls in Zeilen 34 und Spalten 35 angeordnet. Die Zeilen 34 verlaufen insbesondere parallel zu den Zeilen 28. Sie sind insbesondere parallel zur x-Richtung ausgerichtet.

Die Spalten 35 sind insbesondere schräg zur y-Richtung angeordnet. Sie schließen einen Winkel von mindestens 10° mit der y-Richtung ein.

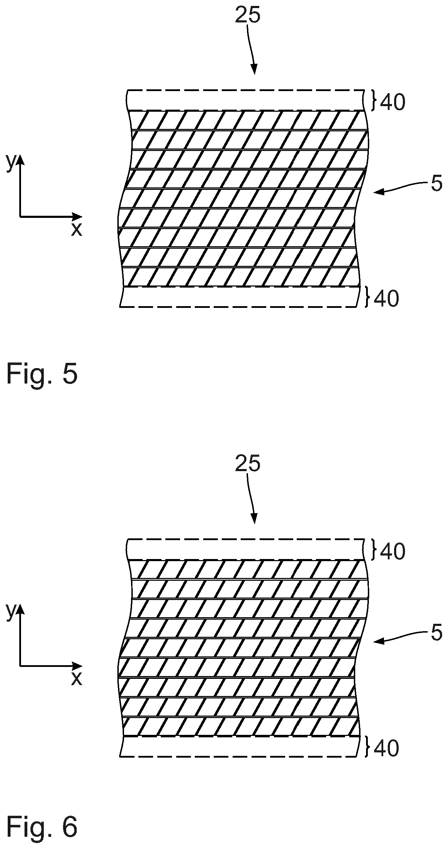

Die Einzelspiegel 31 haben jeweils eine parallelogrammförmige Einzel-Reflexionsfläche 32. Die Kanten der Einzel-Reflexionsfläche 32 sind insbesondere jeweils parallel zu denen der Gesamt-Reflexionsfläche des zugehörigen MMAs 27. Gemäß der in den Fig. 2 und 3 dargestellten Ausführungsform sind die Einzelspiegel 31 insbesondere derart angeordnet, dass die Berandung zweier benachbarter Einzel-Reflexionsflächen 32 jeweils eine fluchtende Linie bildet. Dies führt zu der in Fig. 5 dargestellten Ausleuchtung des Objektfeldes 5.

Alternativ hierzu ist es auch möglich, die Einzelspiegel 31 benachbarter Zeilen derart versetzt zueinander anzuordnen, dass die schräg zur x-Richtung verlaufenden Berandungen zweier benachbarter Einzel-Reflexionsflächen 32 jeweils nicht miteinander fluchten.

Die Einzel-Reflexionsfläche 32 der Einzelspiegel 31 hat insbesondere die Form eines gescherten Rechtecks. In Scanrichtung benachbarte Einzelspiegel 31 sind insbesondere senkrecht zur Scanrichtung so zueinander versetzt, wie es die Scherung vorgibt. Durch eine derartige Anordnung wird eine sehr effiziente Unterdrückung von Intensitätsschwankungen in der Objektebene 6, insbesondere im Objektfeld 5, erreicht.

Es ist insbesondere vorgesehen, dass sämtliche Einzelspiegel 31 des MMAs 27 geometrisch ähnlich, insbesondere identisch zueinander ausgebildet sind.

Die MMAs 27 haben in Scanrichtung eine Ausdehnung, die einem Vielfachen der Ausdehnung einer virtuellen Facette 42 in Scanrichtung entspricht. Bei der exemplarisch in Fig. 7 dargestellten Ausführungsform passen beispielsweise vier virtuelle Facetten 42 in y-Richtung auf ein MMA 27. In x-Richtung können sich die virtuellen Facetten 42 über ein oder mehrere MMAs 27 erstrecken. Sie können sich insbesondere über zwei, drei, vier oder mehr MMAs 27 erstrecken. Die virtuellen Facetten 42 sind in diesem Beispiel parallelogrammförmig ausgebildet. Sie weisen eine Höhe in y-Richtung, das heißt eine Ausdehnung in der der Scanrichtung entsprechenden Richtung, auf, welche der Höhe von neun Einzelspiegeln 31 in dieser Richtung entspricht. In x-Richtung, das heißt in Richtung senkrecht zur Scanrichtung, weisen sie eine Ausdehnung auf, welche der Ausdehnung von 72, 108 oder 144 Einzelspiegeln 31 entspricht. Alternative Ausbildungen der virtuellen Facetten 42 sind jedoch ebenfalls möglich.

Durch die Anordnung einer ganzzahligen Vielzahl von virtuellen Facetten 42 in Scanrichtung auf den MMAs 27 kann erreicht werden, dass die senkrecht zur Scanrichtung verlaufenden Ränder der MMAs 27 nicht in das Nutzgebiet, d. h. nicht ins Objektfeld 5, abgebildet werden. Hierdurch kann die Anzahl der Lücken im Phasenraum reduziert werden. Die Anzahl der Lücken kann insbesondere um 50% reduziert werden.

Die virtuellen Facetten 42 sind insbesondere jeweils derart ausgebildet, dass sie jeweils zu einer vollständigen Ausleuchtung des Objektfeldes 5 in Scanrichtung führen. Sie führen insbesondere jeweils zu einem Beleuchtungsfeld 25, welches in Scanrichtung höchstens um die Toleranzbereiche 40 kleiner ist als das zu beleuchtende Objektfeld 5.

Mit den erfindungsgemäßen MMAs 27 kann ein geringerer Pupillenfüllgrad erzielt werden. Durch die geringere Anzahl an Lücken können Intensitätsschwankungen im Objektfeld 5 reduziert werden.

Durch die Anordnung der MMAs 27, sowie insbesondere der Einzelspiegel 31, in Zeilen 28 bzw. 34 parallel zur x-Richtung, d. h. senkrecht zur Scanrichtung, kann die Füllung des Objektfeldes 5, insbesondere im Falle eines rechteckförmigen Objektfeldes 5, verbessert werden. Auch dies erlaubt eine kleinere Pupillenfüllung und somit eine bessere Auflösung.

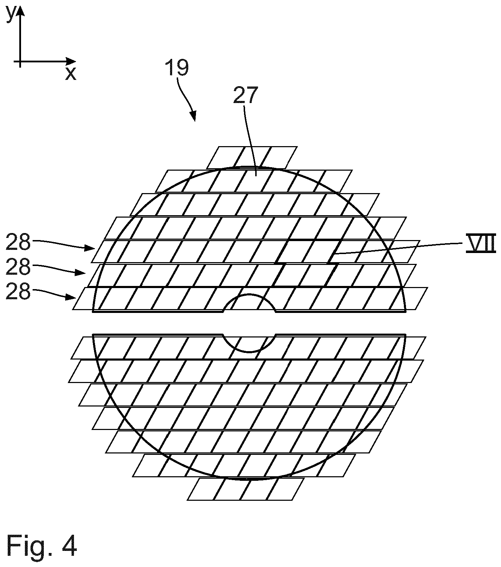

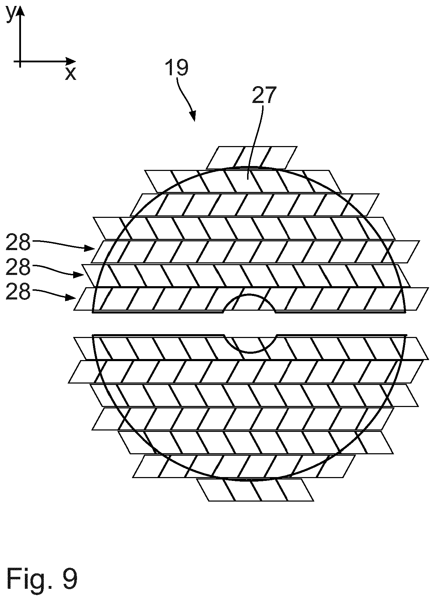

Im Folgenden wird unter Bezugnahme auf die Fig. 9 eine weitere Anordnung der MMAs 27 beschrieben. Während bei der Ausführungsform gemäß Fig. 4 sämtliche MMAs 27 in dieselbe Richtung geschert ausgebildet sind, sodass in der in der Fig. 4 dargestellten zweidimensionalen Projektion zwei beliebige MMAs 27 jeweils parallel verschoben zueinander erscheinen, sind die MMAs 27 benachbarter Zeilen 28 gemäß der in Fig. 9 dargestellten Ausführungsform jeweils in entgegengesetzte Richtungen geschert. Die schräg zu den Zeilen verlaufenden Berandungen der MMAs 27 benachbarter Zeilen 28 sind somit nicht parallel zueinander. Dies führt zu einer Symmetriebrechung, insbesondere in der Pupille, welche zu einer Verbesserung der Eigenschaften der Beleuchtung des Objektfeldes 5 führt.

Allgemein weisen die MMAs 27 benachbarter Zeilen 28 unterschiedliche Scherwinkel auf. Hierunter sei auch verstanden, dass die Scherwinkel, wie in Fig. 9 exemplarisch dargestellt ist, dem Betrag nach gleich sind, jedoch alternierende Vorzeichen aufweisen.

Der Vollständigkeit halber sei angemerkt, dass in den Fig. 4 und 9 die MMAs 27 der Übersichtlichkeit halber vergrößert dargestellt sind. Die tatsächliche Anzahl der MMAs 27 des Facettenspiegels 19 kann wesentlich größer sein als in diesen Figuren dargestellt ist.

Bei der Projektionsbelichtung mit Hilfe der Projektionsbelichtungsanlage 1 wird wenigstens ein Teil des Retikels 7 im Objektfeld 5 auf einen Bereich der lichtempfindlichen Schicht auf dem Wafer 13 im Bildfeld 11 zur lithografischen Herstellung eines mikro- bzw. nanostrukturierten Bauteils, insbesondere eines Halbleiterbauteils, beispielsweise eines Mikrochips, abgebildet. Hierbei können das Retikel 7 und der Wafer 13 zeitlich synchronisiert in Scanrichtung verfahren werden.

**Patentansprüche**

1. Mikrospiegel-Array (27) für eine Projektionsbelichtungsanlage (1) umfassend

   a. eine Vielzahl von Mikrospiegeln (31) mit Einzel-Reflexionsflächen (32), welche jeweils eine nicht-rechteckige Form aufweisen,
   b. wobei das Mikrospiegel-Array (27) eine parallelogramm-förmige nicht-rechteckige Gesamt-Reflexionsfläche aufweist,
   c. wobei sämtliche Mikrospiegel (31) des Mikrospiegel-Arrays (27) geometrisch ähnlich zueinander ausgebildet sind.

2. Mikrospiegel-Array (27) gemäß Anspruch 1, **dadurch gekennzeichnet, dass** die Gesamt-Reflexionsfläche einen glatten Rand (30) aufweist.

3. Mikrospiegel-Array (27) gemäß einem der Ansprüche 1 oder 2, **dadurch gekennzeichnet, dass** die Einzel-Reflexionsflächen (32) eine Form aufweisen, welche geometrisch ähnlich zu der Gesamt-Reflexionsfläche ist.

4. Mikrospiegel-Array (27) gemäß einem vorhergehenden Ansprüche, **dadurch gekennzeichnet, dass** die Einzel-Reflexionsflächen (32) für Strahlung im EUV-Bereich reflektierend sind.

5. Mikrospiegel-Array (27) gemäß einem der vorhergehenden Ansprüche, **dadurch gekennzeichnet, dass** die Mikrospiegel (31) verlagerbar sind und mindestens zwei Kippfreiheitsgrade aufweisen.

6. Optische Baugruppe (26) für eine Projektionsbelichtungsanlage (1) mit mindestens einem Mikrospiegel-Array (27) gemäß einem der vorhergehenden Ansprüche.

7. Optische Baugruppe (26) für eine Projektionsbelichtungsanlage (1) gemäß Anspruch 6, **dadurch gekennzeichnet, dass** sie eine Vielzahl von Mikrospiegel-Arrays (27) gemäß einem der Ansprüche 1 bis 5 aufweist, wobei die Mikrospiegel-Arrays (27) auswechselbar sind, und wobei die Mikrospiegel-Arrays (27) nach Art einer Parkettierung angeordnet sein können.

8. Beleuchtungsoptik (4) zur Überführung von Beleuchtungsstrahlung (16) von einer Strahlungsquelle (2) in ein Objektfeld (5) umfassend eine optische Baugruppe (26) gemäß einem der Ansprüche 6 oder 7.

9. Beleuchtungsoptik (4) gemäß Anspruch 8, **dadurch gekennzeichnet, dass** das mindestens eine Mikrospiegel-Array (27) jeweils derart angeordnet ist, dass es bei Beaufschlagung mit Beleuchtungsstrahlung (16) jeweils zu einem Beleuchtungsfeld (25) in einer Objektebene (6) führt, wobei das Beleuchtungsfeld (25) in einer Scanrichtung eine erste Berandung aufweist, welche einer entsprechenden Berandung des Objektfeldes (5) entspricht.

10. Beleuchtungsoptik (4) gemäß einem der Ansprüche 8 oder 9, **dadurch gekennzeichnet, dass** die Mikrospiegel-Arrays (27) derart angeordnet sind, dass sie eine Begrenzungskante aufweisen, welche senkrecht zur Scanrichtung ausgerichtet ist.

11. Beleuchtungsoptik (4) gemäß einem der Ansprüche 8 bis 10, **dadurch gekennzeichnet, dass** eine Vielzahl von Mikrospiegel-Arrays (27) in Zeilen (28) angeordnet ist, wobei die Mikrospiegel-Arrays (27) mindestens zweier benachbarter Zeilen (28) einen unterschiedlichen Scherwinkel aufweisen.

12. Beleuchtungsoptik (4) gemäß einem der Ansprüche 8 bis 11, **dadurch gekennzeichnet, dass** die Mikrospiegel (31) in Zeilen (34) und Spalten (35) angeordnet sind, wobei die Spalten (35) schräg zu einer Scanrichtung angeordnet sind.

13. Beleuchtungssystem (3) für eine Projektionsbelichtungsanlage (1) umfassend eine Beleuchtungsoptik (4) gemäß einem der Ansprüche 8 bis 12 und eine Strahlungsquelle (2) zur Erzeugung von Beleuchtungsstrahlung (16).

14. Projektionsbelichtungsanlage (1) für die Mikrolithographie umfassend eine Beleuchtungsoptik (4) gemäß einem der Ansprüche 8 bis 12, und eine Projektionsoptik (10).

15. Verfahren zur Herstellung eines mikro- oder nanostrukturierten Bauteils mit folgenden Verfahrensschritten:

   - Bereitstellen eines Wafers (13), auf den zumindest teilweise eine Schicht aus einem lichtempfindlichen Material aufgebracht ist,
   - Bereitstellen eines Retikels (7), das abzubildende Strukturen aufweist,

- Bereitstellen einer Projektionsbelichtungsanlage (1) nach Anspruch 14,
- Projizieren wenigstens eines Teils des Retikels (7) auf einen Bereich der Schicht mit Hilfe einer Projektionsoptik (10) der Projektionsbelichtungsanlage (1).

**Claims**

1. A micromirror array (27) for a projection exposure facility (1) comprising

   a. a plurality of micromirrors (31) having individual reflection surfaces (32), which each have a nonrectangular shape,
   b. wherein the micromirror array (27) has a parallelogram-shaped nonrectangular overall reflection surface,
   c. wherein all micromirrors (31) of the micromirror array (27) are made geometrically similar to one another.

2. The micromirror array (27) according to Claim 1, **characterized in that** the overall reflection surface includes a smooth edge (30).

3. The micromirror array (27) according to one of Claims 1 or 2, **characterized in that** the individual reflection surfaces (32) have a shape which is geometrically similar to the overall reflection surface.

4. The micromirror array (27) according to any one of the preceding claims, **characterized in that** the individual reflection surfaces (32) are reflective to radiation in the EUV range.

5. The micromirror array (27) according to any one of the preceding claims, **characterized in that** the micromirror arrays (31) are movable and have at least two tilt degrees of freedom.

6. An optical assembly (26) for a projection exposure facility (1) having at least one micromirror array (27) according to any one of the preceding claims.

7. The optical assembly (26) for a projection exposure facility (1) according to Claim 6, **characterized in that** it includes a plurality of micromirror arrays (27) according to any one of Claims 1 to 5, wherein the micromirror arrays (27) are exchangeable, and wherein the micromirror arrays (27) can be arranged like a parquet.

8. An illumination optical unit (4) for transferring illumination radiation (16) from a radiation source (2) into an object field (5) comprising an optical assembly (26) according to one of Claims 6 or 7.

9. The illumination optical unit (4) according to Claim 8, **characterized in that** the at least one micromirror array (27) is arranged in each case such that upon application of illumination radiation (16), it results in each case in an illumination field (25) in an object plane (6), wherein the illumination field (25) has a first border in a scanning direction which corresponds to a corresponding border of the object field (5).

10. The illumination optical unit (4) according to one of Claims 8 or 9, **characterized in that** the micromirror arrays (27) are arranged such that they include a boundary edge which is aligned perpendicularly to the scanning direction.

11. The illumination optical unit (4) according to any one of Claims 8 to 10, **characterized in that** a plurality of micromirror arrays (27) is arranged in rows (28), wherein the micromirror arrays (27) of at least two adjacent rows (28) have a different shear angle.

12. The illumination optical unit (4) according to any one of Claims 8 to 11, **characterized in that** the micromirrors (31) are arranged in rows (34) and columns (35), wherein the columns (35) are arranged obliquely in relation to a scanning direction.

13. An illumination system (3) for a projection exposure facility (1) comprising an illumination optical unit (4) according to any one of Claims 8 to 12 and a radiation source (2) for generating illumination radiation (16).

14. A projection exposure facility (1) for microlithography comprising an illumination optical unit (4) according to any one of Claims 8 to 12 and a projection optical unit (10).

15. A method for producing a microstructured and or nanostructured component having the following method steps:

    - providing a wafer (13), on which a layer made of a light-sensitive material is at least partially applied,
    - providing a reticle (7), which includes structures to be imaged,
    - providing a projection exposure facility (1) according to Claim 14,
    - projecting at least a part of the reticle (7) on an area of the layer with the aid of a projection optical unit (10) of the projection exposure facility (1).

**Revendications**

1. Réseau de micro-miroirs (27) destiné à une installation d'illumination par projection (1) comprenant

　　a. un grand nombre de micro-miroirs (31) pourvus de surfaces de réflexion individuelles (32) qui ont chacune une forme non rectangulaire,
　　b. le réseau de micro-miroirs (27) ayant une surface de réflexion totale non rectangulaire en forme de parallélogramme,
　　c. tous les micro-miroirs (31) du réseau de micro-miroirs (27) étant conçus pour être géométriquement similaires les uns aux autres.

2. Réseau de micro-miroirs (27) selon la revendication 1, **caractérisé en ce que** la surface de réflexion totale présente un bord lisse (30).

3. Réseau de micro-miroirs (27) selon l'une des revendications 1 ou 2, **caractérisé en ce que** les surfaces de réflexion individuelles (32) ont une forme qui est géométriquement similaire à la surface de réflexion totale.

4. Réseau de micro-miroirs (27) selon l'une des revendications précédentes, **caractérisé en ce que** les surfaces de réflexion individuelles (32) sont réfléchissantes pour un rayonnement dans la gamme des EUV.

5. Réseau de micro-miroirs (27) selon l'une des revendications précédentes, **caractérisé en ce que** les micro-miroirs (31) sont déplaçables et présentent au moins deux degrés de liberté d'inclinaison.

6. Ensemble optique (26) destiné à une installation d'illumination par projection (1) comprenant au moins un réseau de micro-miroirs (27) selon l'une des revendications précédentes.

7. Ensemble optique (26) destiné à une installation d'illumination par projection (1) selon la revendication 6, **caractérisé en ce qu'**il comporte un grand nombre de réseaux de micro-miroirs (27) selon l'une des revendications 1 à 5, les réseaux de micro-miroirs (27) étant interchangeables, et les réseaux de micro-miroirs (27) pouvant être disposés à la manière d'un parquetage.

8. Optique d'éclairage (4) pour transférer un rayonnement d'éclairage (16) d'une source de rayonnement (2) dans un champ objet (5) comprenant un ensemble optique (26) selon l'une des revendications 6 ou 7.

9. Optique d'éclairage (4) selon la revendication 8, **caractérisée en ce que** l'au moins un réseau de micro-miroirs (27) est disposé de manière à ce que, lorsqu'il est soumis à un rayonnement d'éclairage (16), il mène à un champ d'éclairage (25) dans un plan objet (6), le champ d'éclairage (25) présentant dans une direction de balayage une première limite qui correspond à une limite correspondante du champ objet (5).

10. Optique d'éclairage (4) selon l'une des revendications 8 ou 9, **caractérisée en ce que** les réseaux de micro-miroirs (27) sont disposés de manière à ce qu'ils présentent un bord limite qui est orienté perpendiculairement à la direction de balayage.

11. Optique d'éclairage (4) selon l'une des revendications 8 à 10, **caractérisée en ce qu'**un grand nombre de réseaux de micro-miroirs (27) sont disposés en lignes (28), les réseaux de micro-miroirs (27) d'au moins deux lignes adjacentes (28) présentent un angle de cisaillement différent.

12. Optique d'éclairage (4) selon l'une des revendications 8 à 11, **caractérisée en ce que** les micro-miroirs (31) sont disposés en lignes (34) et colonnes (35), les colonnes (35) étant disposées obliquement par rapport à une direction de balayage.

13. Système d'éclairage (3) destiné à une installation d'illumination par projection (1) comprenant une optique d'éclairage (4) selon l'une des revendications 8 à 12 et une source de rayonnement (2) destinée à générer un rayonnement d'éclairage (16).

14. Installation d'illumination par projection (1) destinée à la microlithographie, ladite installation comprenant une optique d'éclairage (4) selon l'une des revendications 8 à 12, et une optique de projection (10) .

15. Procédé de fabrication d'un composant micro- ou nanostructuré, ledit procédé comprenant les étapes suivantes :

　　- fournir une plaquette (13) sur laquelle une couche d'un matériau photosensible est appliquée au moins partiellement,
　　- fournir un réticule (7) qui comporte des structures à reproduire,
　　- fournir une installation d'illumination par projection (1) selon la revendication 14,
　　- projeter au moins une partie du réticule (7) sur une zone de la couche à l'aide de l'optique de projection (10) de l'installation d'illumination par projection (1) .

Fig. 1

EP 3 039 485 B1

Fig. 2

Fig. 3

EP 3 039 485 B1

y

x

19

27

28

28

28

VII

Fig. 4

13

25

}40

5

}40

y

x

Fig. 5

25

}40

5

}40

y

x

Fig. 6

Fig. 7

Fig. 8

Fig. 9

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- WO 2010099807 A1
- DE 102012207866
- US 2004125346 A1
- US 6859515 B2
- EP 1225481 A